# EUROPEAN PATENT APPLICATION

(11) **EP 3 922 747 A1**
(43) Date of publication of application: **15.12.2021**
(21) Application number: 20752156.8
(22) Date of filing: 23.01.2020
(51) Int. Cl.: C23C 14/34, C22C 5/06, C22F 1/00, C22F 1/14, C23C 14/06, H01L 21/285

(54) **AG ALLOY SPUTTERING TARGET, AND AG ALLOY FILM**

(30) Priority: 06.02.2019 JP 2019020063
(71) Applicant: Mitsubishi Materials Corporation, Tokyo 100-8117 (JP)
(72) Inventor: TOSHIMORI Yuto, Naka-shi, Ibaraki 311-0102 (JP); NONAKA Sohei, Naka-shi, Ibaraki 311-0102 (JP)
(74) Representative: Hoffmann Eitle
(86) International application number: PCT/JP2020/002330
(87) International publication number: WO 2020/162206

(57) **Abstract**

An Ag alloy sputtering target includes Mg in a range of 1.0 atom% or more and 5.0 atom% or less, Au in a range of 0.10 atom% or more and 5.00 atom% or less, and a balance consisting of Ag and inevitable impurities. The Ag alloy sputtering target may further include Ca in a range of 0.01 atom% or more and 0.15 atom% or less. In addition, the oxygen content may be 0.010 % by mass or less.

## Description

### [Technical Field]

The present invention relates to an Ag alloy sputtering target used in a case of forming an Ag alloy film which can be applied to, for example, a transparent conductive film for a display or a touch panel or a metal thin film of an optically functional film, and an Ag alloy film.

Priority is claimed on Japanese Patent Application No. 2019-020063, filed February 6, 2019, the content of which is incorporated herein by reference.

### [Background Art]

For example, in a liquid crystal display, an organic EL display, a touch panel, and the like, a multilayer film having a laminated structure of a transparent conductive oxide film and an Ag film containing Ag or an Ag alloy is used as a transparent conductive film configuring a wiring and an electrode, for example, as disclosed in Patent Documents 1 to 3. This multilayer film is necessary to have a high transmittance of light in a visible light region and a low electrical resistance.

In addition, in a case of forming an Ag film containing Ag or an Ag alloy on a glass substrate or the like, for example, a sputtering method using a sputtering target containing Ag or an Ag alloy is widely used as disclosed in Patent Document 4.

### [Citation List]

### [Patent Documents]

[Patent Document 1]
   Japanese Unexamined Patent Application, First Publication No. 2006-028641
[Patent Document 2]
   Japanese Unexamined Patent Application, First Publication No. H09-291356
[Patent Document 3]
   Japanese Unexamined Patent Application, First Publication No. H10-239697
[Patent Document 4]
   Japanese Unexamined Patent Application, First Publication No. 2016-040411

### [Summary of Invention]

### [Technical Problem]

However, in the multilayer film or the Ag film described above, particles, fingerprints, sweat, and the like are attached to a film surface or a film end surface, and the Ag film may corrode due to chlorine (Cl) contained therein, and this may cause poor appearance. In addition, the corrosion of the Ag film may cause poor conductivity and the Ag film may not function as wiring or electrodes. Even in a case of the multilayer film in which a transparent conductive oxide film is formed on an Ag film, chlorine (CI) may pass through the transparent conductive oxide film and corrode the Ag film.

The present invention has been made in view of the above-mentioned circumstances, and an object thereof is to provide an Ag alloy sputtering target capable of suppressing corrosion due to chlorine (Cl) and forming an Ag alloy film having excellent environmental resistance, and an Ag alloy film.

### [Solution to Problem]

In order to solve the above problems, there is provided an Ag alloy sputtering target according to an aspect of the present invention including: Mg in a range of 1.0 atom% or more and 5.0 atom% or less, Au in a range of 0.10 atom% or more and 5.00 atom% or less, and a balance consisting of Ag and inevitable impurities.

The Ag alloy sputtering target having this configuration contains 1.0 atom% or more of Mg having a chloride formation free energy lower than that of Ag. Accordingly, Mg generates chloride with priority, when it comes into contact with chlorine (Cl). In addition, since Au is contained in an amount of 0.10 atom% or more, this Au is dissolved in Ag, and a reaction between Ag and chlorine (CI) is suppressed. Therefore, it is possible to suppress the corrosion of the formed Ag alloy film due to chlorine (CI).

In addition, since the Mg content is limited to 5.0 atom% or less, it is possible to suppress an increase in a resistance value of the formed Ag alloy film, and it is possible to ensure conductivity.

In addition, since the Au content is limited to 5.00 atom% or less, it is possible to suppress a deterioration in optical properties of the formed Ag alloy film, and it is possible to ensure light transmittance.

The Ag alloy sputtering target according to the aspect of the present invention may further include Ca in a range of 0.01 atom% or more and 0.15 atom% or less.

In this case, 0.01 atom% or more of Ca having a chloride formation free energy lower than that of Ag is contained. Accordingly, Ca generates chloride with priority together with Mg, when it comes into contact with chlorine (Cl), and further suppress the corrosion of the formed Ag alloy film due to chlorine (Cl).

In addition, since the Ca content is limited to 0.15 atom% or less, it is possible to suppress the occurrence of cracks during processing and stably manufacture this Ag alloy sputtering target.

In addition, in the Ag alloy sputtering target according to the aspect of the present invention, it is preferable that an oxygen content is 0.010 % by mass or less.

Since the Ag alloy sputtering target according to the embodiment of the present invention contains a large amount of Mg, which is an easily oxidizing element, as described above, Mg oxide may be generated. Since this Mg oxide is an insulating material, it causes an abnormal discharge during sputtering film formation. Therefore, by limiting the oxygen content to 0.010 % by mass or less, it is possible to suppress the generation of Mg oxide and suppress the occurrence of abnormal discharge during sputtering film formation.

According to another aspect of the present invention, there is provided an Ag alloy film including: Mg in a range of 1.0 atom% or more and 5.0 atom% or less, Au in a range of 0.10 atom% or more and 5.00 atom% or less, and a balance consisting of Ag and inevitable impurities.

The Ag alloy film having this configuration contains 1.0 atom% or more of Mg having a chloride formation free energy lower than that of Ag. Accordingly, Mg generates chloride with priority, when it comes into contact with chlorine (Cl). In addition, since Au is contained in an amount of 0.10 atom% or more, this Au is dissolved in Ag, and a reaction between Ag and chlorine (Cl) is suppressed. Therefore, it is possible to suppress the corrosion due to chlorine (Cl) and suppress the occurrence of poor appearance and conduction failure.

In addition, since the Mg content is limited to 5.0 atom% or less, it is possible to suppress an increase in a resistance value, and it is possible to ensure conductivity.

In addition, since the Au content is limited to 5.00 atom% or less, it is possible to suppress a deterioration in optical properties, and it is possible to ensure light transmittance.

The Ag alloy film according to the aspect of the present invention may further include Ca in a range of 0.01 atom% or more and 0.15 atom% or less.

In this case, 0.01 atom% or more of Ca having a chloride formation free energy lower than that of Ag is contained. Accordingly, Ca generates chloride with priority together with Mg, when it comes into contact with chlorine (Cl), and further suppress the corrosion due to chlorine (Cl).

In addition, since the Ca content is limited to 0.15 atom% or less, it is possible to stably manufacture this Ag alloy sputtering target used in a case of forming the Ag alloy film.

In addition, in the Ag alloy film according to the aspect of the present invention, it is preferable that an oxygen content is 0.010 % by mass or less.

In this case, since the oxygen content is limited to 0.010 % by mass or less, it is possible to suppress the consumption of Mg by oxygen, and it is possible to reliably suppress the corrosion of Ag by Mg.

### [Advantageous Effects of Invention]

According to the present invention, it is possible to provide an Ag alloy sputtering target capable of suppressing corrosion due to chlorine (Cl) and forming an Ag alloy film having excellent environmental resistance, and an Ag alloy film.

### [Brief Description of Drawings]

Fig. 1 is a cross-sectional explanatory diagram of a multilayer film including an Ag alloy film according to an embodiment of the present invention.
Fig. 2A is an observation result of a film end portion of an Ag alloy film of Example 1 of the present invention after a constant temperature and humidity test in examples.
Fig. 2B is an observation result of a film central portion of an Ag alloy film of Example 1 of the present invention after the constant temperature and humidity test in examples.
Fig. 3A is an observation result of a film end portion of an Ag alloy film of Comparative Example 1 after the constant temperature and humidity test in examples.
Fig. 3B is an observation result of a film central portion of an Ag alloy film of Comparative Example 1 after the constant temperature and humidity test in examples.

### [Description of Embodiments]

Hereinafter, an Ag alloy sputtering target and an Ag alloy film according to one embodiment of the present invention will be described.

An Ag alloy sputtering target of the present embodiment is used in a case of forming an Ag alloy film.

As described above, the Ag alloy sputtering target of the present embodiment is used for forming the Ag alloy film by sputtering. A shape of the Ag alloy sputtering target is not particularly limited, and may be a rectangular flat plate type having a rectangular sputtering surface or a circular plate type having a circular sputtering surface. Alternatively, it may be a cylindrical type in which the sputtering surface is a cylindrical surface.

The Ag alloy sputtering target of the present embodiment contains an Ag alloy having a composition of Mg in a range of 1.0 atom% or more and 5.0 atom% or less, Au in a range of 0.10 atom% or more and 5.00 atom% or less, and a balance consisting of Ag and inevitable impurities.

In addition, the Ag alloy sputtering target of the present embodiment may further include Ca in a range of 0.01 atom% or more and 0.15 atom% or less.

Further, the Ag alloy sputtering target of the present embodiment, it is preferable that an oxygen content is limited to 0.010 % by mass or less.

In addition, an Ag alloy film 11 of the present embodiment is used as a transparent conductive film of an electronic device such as a touch panel, a solar cell, or an organic EL device, or a metal thin film of an optically functional film.

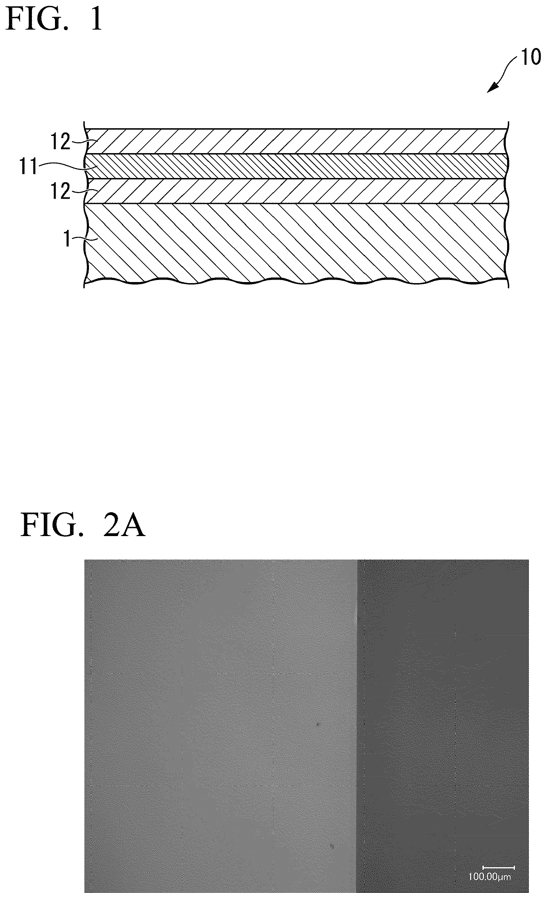

In the present embodiment, as shown in Fig. 1, a transparent conductive film formed of a multilayer film 10 is configured.

The multilayer film 10 shown in Fig. 1 includes the Ag alloy film 11 formed on one surface of a substrate 1 containing glass or the like, and transparent conductive oxide films 12 formed on both surfaces of the Ag alloy film 11.

In the multilayer film 10 shown in Fig. 1, a film thickness of the Ag alloy film is preferably in a range of 5 nm or more and 20 nm or less. In addition, the film thickness of the transparent conductive oxide film 12 is preferably in a range of 5 nm or more and 50 nm or less.

The Ag alloy film 11 is formed by using the Ag alloy sputtering target described above, contains a composition of Mg in a range of 1.0 atom% or more and 5.0 atom% or less, Au in a range of 0.10 atom% or more and 5.00 atom% or less, and a balance consisting of Ag and inevitable impurities.

In addition, the Ag alloy film 11 of the present embodiment may further include Ca in a range of 0.01 atom% or more and 0.15 atom% or less.

Further, the Ag alloy film 11 of the present embodiment, it is preferable that an oxygen content is limited to 0.010 % by mass or less.

The transparent conductive oxide film 12 is formed of a transparent conductive oxide including any one or two or more selected from an In oxide, a Sn oxide, a Zn oxide, a Nb oxide, a Ti oxide, an A1 oxide, and a Ga oxide. Specifically, examples thereof include an In-Sn oxide (ITO), an Al-Zn oxide (AZO), an In-Zn oxide (IZO), a Zn-Sn oxide (ZTO), a Zn-Sn-Al oxide (AZTO), a Ga-Zn oxide (GZO), a Zn-Y oxide (ZYO), a Ga-Zn-Y oxide (GZYO), and the like.

The composition of the transparent conductive oxide film 12 is preferably suitably selected according to the required properties.

In the Ag alloy sputtering target and the Ag alloy film 11 of the embodiment, the reasons for setting the component composition as described above will be described.

### (Mg)

Mg is an element that has a lower chloride formation free energy than that of Ag and easily produces chloride. Therefore, by containing Mg, chlorine (CI) and Mg can be preferentially reacted, and the corrosion of Ag can be suppressed.

In a case where a Mg content is less than 1.0 atom%, the operation effects described above may not be sufficiently obtained. On the other hand, in a case where the Mg content exceeds 5.0 atom%, a resistance value of the formed Ag alloy film may increase and conductivity may decrease.

For this reason, in the present embodiment, the Mg content is set in a range of 1.0 atom% or more and 5.0 atom% or less.

In order to further suppress the corrosion of Ag due to chlorine (CI), a lower limit of the Mg content is preferably 1.5 atom% or more, and more preferably 2.0 atom% or more. On the other hand, in order to further suppress an increase in the resistance value of the formed Ag alloy film, the upper limit of the Mg content is preferably 4.5 atom% or less, and more preferably 4.0 atom% or less.

### (Au)

Au is an element that has an effect of suppressing a reaction between Ag and chlorine (Cl) by being dissolved in a mother phase of Ag.

In a case where a Au content is less than 0.10 atom%, the operation effects described above may not be sufficiently obtained. On the other hand, in a case where the Au content exceeds 5.00 atom%, optical properties of the formed Ag alloy film deteriorate and transmittance may decrease.

For this reason, in the present embodiment, the Au content is set in a range of 0.10 atom% or more and 5.00 atom% or less.

In order to further suppress the reaction between chlorine (Cl) and Ag and further suppress the corrosion of Ag, a lower limit of the Au content is preferably 0.50 atom% or more, and more preferably 1.00 atom% or more. On the other hand, in order to further suppress a deterioration in optical properties of the formed Ag alloy film, the upper limit of the Au content is preferably 4.50 atom% or less, and more preferably 4.00 atom% or less.

### (Ca)

Ca is an element that has a lower chloride formation free energy than that of Ag and easily produces chloride, in the same manner as Mg. Therefore, by containing Ca, chlorine (Cl) and Mg can be preferentially reacted, and the corrosion of Ag can be further suppressed.

By setting the Ca content to 0.01 atom% or more, it is possible to further suppress the corrosion of Ag due to chlorine (Cl). On the other hand, by limiting the Ca content to 0.15 atom% or less, it is possible to ensure workability and suppress the occurrence of cracks during processing.

For this reason, in the embodiment, in a case where the Ca is added, the Ca content is preferably in a range of 0.01 atom% or more and 0.15 atom% or less.

In order to further suppress the reaction between chlorine (Cl) and Ag and further suppress the corrosion of Ag, a lower limit of the Ca content is preferably 0.02 atom% or more, and more preferably 0.05 atom% or more. On the other hand, in order to further ensure workability and further suppress occurrence of cracks during process, the upper limit of the Ca content is preferably 0.13 atom% or less and more preferably 0.10 atom% or less.

In addition, in a case where Ca is not intentionally added, the Ca content may be less than 0.01 atom%.

### (Oxygen content)

In the Ag alloy sputtering target of the present embodiment, in a case where an oxygen content is limited to 0.010 % by mass or less, it is possible to suppress the oxidation of Mg, which is an easily oxidizing element and suppress the generation of Mg oxide, which is an insulating material. Accordingly, it is possible to suppress occurrence of abnormal discharge during sputtering film formation and stably form the Ag alloy film. In addition, it is possible to suppress the consumption of Mg as an oxide, and it is possible to reliably suppress the corrosion of Ag by Mg.

For this reason, in the present embodiment, the oxygen content is preferably limited to 0.010 % by mass or less.

In order to further suppress the generation of Mg oxide and suppress the occurrence of abnormal discharge during sputtering film formation, the oxygen content is preferably 0.008 % by mass or less, and more preferably 0.005 % by mass or less.

In addition, the lower limit of the oxygen content is not particularly limited, but industrially, it is not preferable to set it to less than 0.001 % by mass, because the manufacturing cost increases significantly.

Next, a method for manufacturing the Ag alloy sputtering target according to the embodiment will be described.

First, an Ag raw material having a purity of 99.9 % by mass or more and auxiliary raw materials of Au and Mg having a purity of 99.9 % by mass or more are prepared. If necessary, an auxiliary raw material for Ca having a purity of 99.9 % by mass or more is prepared.

Next, the Ag raw material is dissolved in a melting furnace under a high vacuum or an inert gas atmosphere, and a predetermined amount of auxiliary raw materials (Au, Mg, and if necessary, Ca) are added to the obtained molten Ag to obtain a molten Ag alloy. Then, the molten Ag alloy is supplied to a mold to obtain an Ag alloy ingot having a predetermined composition.

In order to reduce the oxygen content in the Ag alloy ingot, for dissolving the Ag raw material, the inside of a melting furnace is set to temporarily high vacuum (5 x 10⁻² Pa or less), an operation of replacing to close to atmospheric pressure with inert gas (argon or nitrogen) is preferably repeated three or more times, then, the Ag raw material is dissolved under the inert gas atmosphere, and the auxiliary raw materials are preferably put. The auxiliary raw materials (Au, Mg, if necessary, Ca) may be added as a mother alloy (for example, Ag-Ca alloy or the like) produced in advance.

Next, the obtained Ag alloy ingot is cold-worked. A cumulative rolling reduction at this time is preferably 70% or more.

Subsequently, the obtained cold-worked material is heat-treated in an atmosphere under the conditions of a heat treatment temperature of 500°C or higher and 700°C or lower and a holding time at the heat treatment temperature of 1 hour or longer and 5 hours or shorter.

Then, the obtained heat-treated material is subjected to machining such as cutting to finish it in a predetermined shape and dimensions.

By the step described above, the Ag alloy sputtering target of the embodiment is manufactured.

Next, a method for manufacturing the Ag alloy film according to this embodiment will be described.

The Ag alloy film of the present embodiment is formed by using the Ag alloy sputtering target of the embodiment described above.

The Ag alloy sputtering target described above is, for example, mounted on a sputtering device by soldering a backing material formed of oxygen-free copper to perform the sputtering. Accordingly, the Ag alloy film of the embodiment is formed on a surface of a substrate.

In the sputtering device to be used, a static facing type of sputtering by fixing a substrate for forming the Ag alloy film may be used or a substrate transfer type of sputtering while transporting the substrate (inline type) may be used.

In addition, as a power source of the sputtering device, for example, a direct current (DC) power source, a radio frequency (RF) power source, a medium frequency (MF) power source, or an alternating current (AC) power source can be used.

According to the Ag alloy sputtering target and the Ag alloy film 11 of the present embodiment having the configuration described above, contains 1.0 atom% or more of Mg having a chloride formation free energy lower than that of Ag. Accordingly, Mg generates chloride with priority, when it comes into contact with chlorine (CI). In addition, since Au is contained in an amount of 0.10 atom% or more, this Au is dissolved in Ag, and a reaction between Ag and chlorine (Cl) is suppressed. Therefore, it is possible to suppress the corrosion of the Ag alloy film 11 due to chlorine (Cl).

In addition, since the Mg content is limited to 5.0 atom% or less, it is possible to suppress an increase in a resistance value of the Ag alloy film 11, and it is possible to ensure conductivity.

In addition, since the Au content is limited to 5.00 atom% or less, it is possible to suppress a deterioration in optical properties of the Ag alloy film 11, and it is possible to ensure light transmittance.

In addition, in the embodiment, in a case where the Ca content is in a range of 0.01 atom% or more and 0.15 atom% or less, Ca generates chloride with priority together with Mg, when it comes into contact with chlorine (Cl), and further suppress the corrosion of the Ag alloy film 11 due to chlorine (Cl).

On the other hand, since the Ca content is limited to 0.15 atom% or less, it is possible to suppress the occurrence of cracks during processing and stably manufacture this Ag alloy sputtering target.

In addition, in the present embodiment, in a case where an oxygen content is limited to 0.010 % by mass or less, it is possible to suppress generation of the Mg oxide which is an insulating material by suppressing the oxidation of Mg, which is an easily oxidizing element, and suppress the occurrence of abnormal discharge during sputtering film formation.

Further, it is possible to suppress the consumption of Mg due to an oxygen, and it is possible to reliably suppress the corrosion of Ag by Mg.

Although the embodiment of the present invention has been described above, the present invention is not limited thereto and can be appropriately modified within a range not departing from the technical idea of the invention.

For example, in the present embodiment, as shown in Fig. 1, the Ag alloy film configuring the multilayer film has been described, but there is no limitation thereto, and the Ag alloy film of the present invention may be used as a single film.

In addition, in the present embodiment, it is described that the sputtering target is manufactured by cold rolling the Ag alloy ingot, but the present invention is not limited thereto, and other manufacturing methods may be applied. As the manufacturing method, it is preferable to suitably select a known method according to the shape of the Ag alloy sputtering target to be manufactured.

### [Examples]

The results of confirmation experiments performed to confirm the effectiveness of the present invention will be described hereinafter by using the examples of the present invention.

### <Ag Alloy Sputtering Target>

An Ag raw material having a purity of 99.9 % by mass or more and an auxiliary raw material of Au and Mg (Ca) having a purity of 99.9 % by mass or more were prepared and these were weighed to have a predetermined blending ratio.

Next, the Ag raw material was dissolved in a melting furnace under a high vacuum or an inert gas atmosphere, and the auxiliary raw materials (Au, Mg, Ca) were added to the obtained molten Ag to obtain a molten Ag alloy. Then, the molten Ag alloy was supplied to a mold to obtain an Ag alloy ingot having a predetermined composition.

For dissolving the Ag raw material, the inside of a melting furnace was set to temporarily high vacuum (5 x 10⁻² Pa or less), and an operation of replacing to close to atmospheric pressure with inert gas (argon or nitrogen) was repeated three or more times. Then, the Ag raw material was dissolved under the inert gas atmosphere, and the auxiliary raw materials were put.

Then, the obtained Ag alloy ingot was cold-rolled at a rolling reduction of 80%, and then heat-treated in the atmosphere at 600°C for 1 hour.

By performing the machining, an Ag alloy sputtering target having a predetermined dimension (126 mm × 178 mm × thickness of 6 mm) was obtained.

### (Composition of Ag Alloy Sputtering Target)

A measurement sample was collected from the obtained Ag alloy ingot and analyzed by ICP emission spectroscopy. In addition, the oxygen content was measured by an inert gas dissolving-infrared absorption method (JIS H 1067). The measurement results are shown in Table 1.

### (Number of times of abnormal discharges)

After discharging the air inside of the sputtering device to have a pressure of 5 × 10⁻⁵ Pa, and the sputtering was performed under the conditions of an Ar gas pressure of 0.5 Pa, an input power of direct current of 1000 W, and a distance between target substrates of 70 mm. The number of times of abnormal discharges during the sputtering was measured as the number of times of abnormal discharges for 6 hours from the start of discharge by an arc count function of a DC power supply (RPDG-50A) manufactured by MKS Instruments. The measurement results are shown in Table 1.

### <Ag alloy film>

A multilayer film was formed as follows using the Ag alloy sputtering target obtained as described above.

First, as a substrate, a glass substrate having a size of 10 cm × 30 cm (EAGLEXG manufactured by Corning) was prepared.

In addition, a sputtering target formed of ITO (In₂O₃ - 10 % by mass SnO₂) was prepared as a sputtering target for forming a transparent conductive oxide film.

The sputtering target and Ag alloy sputtering target described above were soldered to a backing plate formed of oxygen-free copper, and this was mounted on a sputtering device. In the embodiment, a magnetron DC sputtering device was used. In addition, in the embodiment, a substrate transfer type sputtering device which performs sputtering while transporting a substrate was used.

Then, the sputtering was performed under the following conditions to form the transparent conductive oxide film and the Ag alloy film on the substrate to obtain a multilayer film having a layer structure shown in Table 2.
Film formation start vacuum degree: 7.0 × 10⁻⁴ Pa or less
Sputtering gas: High-purity argon
Sputtering gas pressure in chamber: 0.4 Pa
DC power: 100 W

### (Composition of Ag Alloy Film)

Under the conditions described above, a metal film was formed on a glass substrate to have a thickness of 1,000 nm and the component composition thereof was measured by ICP emission spectroscopy. In addition, the oxygen content was measured by an inert gas dissolving-infrared absorption method (JIS H 1067). As a result, it was confirmed that the composition of the Ag alloy film was the same as the composition of the Ag alloy sputtering target used.

### (Film Thickness Measurement)

In a case of forming a film by sputtering, the sputtering rate was measured by measuring the film thickness after film formation for a certain period of time with a step gauge (DEKTAK-XT), and the film formation time was adjusted based on the value thereof to form a film with a target thickness.

A film thickness of the actual multilayer film was confirmed by observing the cross section of the multilayer film with a transmission electron microscope (TEM), and it was confirmed that the film thickness was formed as intended. For sample preparation for the TEM observation, for example, a cross section polisher (CP) or a focused ion beam (FIB) can be used.

### (Evaluation of electrical characteristics of multilayer film)

The sheet resistance of the multilayer film was measured by a four-point probe method using a resistance meter Loresta GP manufactured by Mitsubishi Chemical Corporation. The evaluation results are shown in Table 2.

### (Evaluation of optical characteristics of multilayer film)

The transmittance of the multilayer film was measured using a spectrophotometer (U-4100 manufactured by Hitachi High-Technologies Corporation). The evaluation results are shown in Table 2. Table 2 shows average values of the transmittance at a wavelength of 380 nm to 780 nm.

### (Evaluation of environmental resistance of multilayer film)

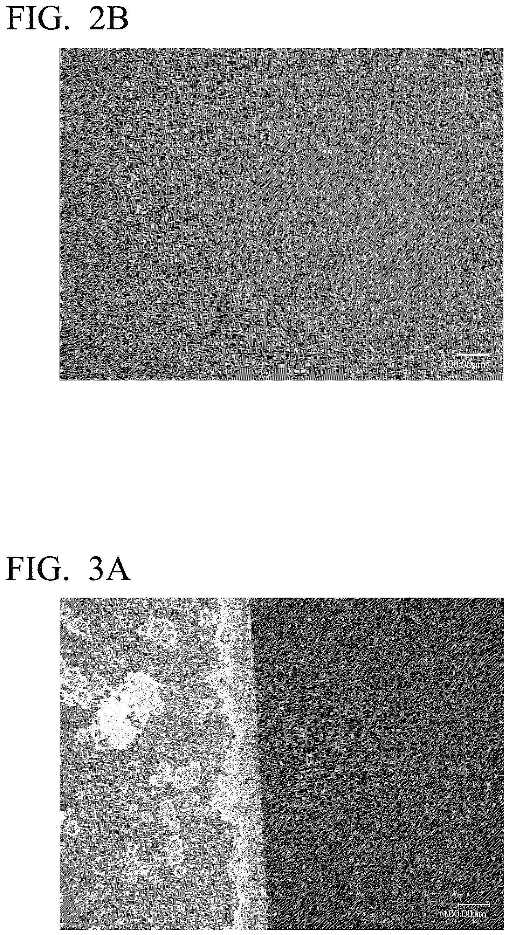

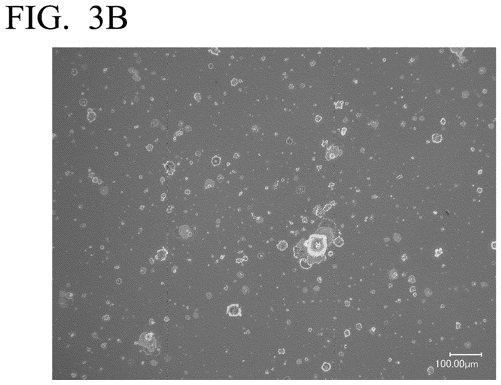

The multilayer film was held in a constant temperature and humidity chamber at a temperature of 85°C and a humidity of 85% for 250 hours, and the appearance of the film after the test was observed with an optical microscope to determine the presence or absence of discoloration (poor appearance). The evaluation results are shown in Table 2. Figs. 2A, 2B, 3A, and 3B show examples of observation of the multilayer film after the constant temperature and humidity test. Fig. 2A is an observation result of the film end portion of the Ag alloy film of Example 1 of the present invention, and Fig. 2B is an observation result of the film central portion of the Ag alloy film of Example 1 of the present invention. In addition, Fig. 3A is an observation result of the film end portion of the Ag alloy film of Comparative Example 1, and Fig. 3B is an observation result of the film central portion of the Ag alloy film of Comparative Example 1.

The discoloration occurs, in a case where corrosion due to chlorine (Cl) contained in particles attached to the multilayer film is accelerated by the constant temperature and humidity test.

**[Table 1]**

| | | Composition of target | | | | | Number of times of occurrence of abnormal discharge (times) |
|---|---|---|---|---|---|---|---|
| | | Mg (atom%) | Au (atom%) | Ca (atom%) | Oxygen (% by mass) | Ag | |
| Example of present invention | 1 | 3.0 | 0.10 | - | 0.001 | Balance | 0 |
| | 2 | 3.0 | 1.00 | - | 0.002 | Balance | 0 |
| | 3 | 3.0 | 3.00 | - | 0.001 | Balance | 0 |
| | 4 | 3.0 | 5.00 | - | 0.001 | Balance | 0 |
| | 5 | 1.0 | 3.00 | - | 0.001 | Balance | 0 |
| | 6 | 5.0 | 3.00 | - | 0.001 | Balance | 0 |
| | 7 | 3.0 | 3.00 | 0.01 | 0.002 | Balance | 0 |
| | 8 | 3.0 | 3.00 | 0.15 | 0.001 | Balance | 0 |
| | 9 | 3.0 | 3.00 | - | 0.030 | Balance | 12 |
| Comparative Example | 1 | 3.0 | 0.02 | - | 0.001 | Balance | 0 |
| | 2 | 3.0 | 6.50 | - | 0.001 | Balance | 0 |
| | 3 | 0.4 | 2.00 | - | 0.001 | Balance | 0 |
| | 4 | 7.0 | 2.00 | - | 0.001 | Balance | 0 |
| | 5 | 3.0 | 3.00 | 0.21 | 0.002 | Balance | Crack during rolling |

**[Table 2]**

| | | Multilayer film | | | Sheet resistance (Ω/) | Average transmittance (%) | Presence or absence of discoloring after constant temperature and humidity test |
|---|---|---|---|---|---|---|---|
| | | First layer | Second layer | Third layer | | | |
| Example of present invention | 101 | ITO (40nm) | Example 1 of present invention (8nm) | ITO (40nm) | 9 | 85.0 | Absent |
| | 102 | ITO (40nm) | Example 2 of present invention (8nm) | ITO (40nm) | 11 | 84.5 | Absent |
| | 103 | ITO (40nm) | Example 3 of present invention (8nm) | ITO (40nm) | 13 | 83.6 | Absent |
| | 104 | ITO (40nm) | Example 4 of present invention (8nm) | ITO (40nm) | 15 | 82.1 | Absent |
| | 105 | ITO (40nm) | Example 5 of present invention (8nm) | ITO (40nm) | 11 | 83.8 | Absent |
| | 106 | ITO (40nm) | Example 6 of present invention (8nm) | ITO (40nm) | 19 | 83.4 | Absent |
| | 107 | ITO (40nm) | Example 7 of present invention (8nm) | ITO (40nm) | 13 | 83.7 | Absent |
| | 108 | ITO (40nm) | Example 8 of present invention (8nm) | ITO (40nm) | 12 | 83.8 | Absent |
| | 109 | ITO (40nm) | Example 9 of present invention (8nm) | ITO (40nm) | 13 | 83.8 | Absent |
| Comparative Example | 101 | ITO (40nm) | Comparative Example 1 (8nm) | ITO (40nm) | 10 | 85.2 | Present |
| | 102 | ITO (40nm) | Comparative Example 2 (8nm) | ITO (40nm) | 19 | 79.9 | Absent |
| | 103 | ITO (40nm) | Comparative Example 3 (8nm) | ITO (40nm) | 11 | 84.5 | Present |
| | 104 | ITO (40nm) | Comparative Example 4 (8nm) | ITO (40nm) | 26 | 83.0 | Absent |

In a multilayer film of Comparative Example 101 including an Ag alloy film formed by using the Ag alloy sputtering target of Comparative Example 1 having a Au content of 0.02 atom%, as shown in Figs. 3A to 3B, after the constant temperature and humidity test, a discolored part was observed on the Ag alloy film. It is surmised that it is because the corrosion suppressing effect of Au was not sufficient and the corrosion due to chlorine (Cl) occurred.

In a multilayer film of Comparative Example 102 including an Ag alloy film formed by using the Ag alloy sputtering target of Comparative Example 2 having a Au content of 6.50 atom%, the transmittance was low.

In a multilayer film of Comparative Example 103 including an Ag alloy film formed by using the Ag alloy sputtering target of Comparative Example 3 having a Mg content of 0.4 atom%, after the constant temperature and humidity test, a discolored part was observed on the Ag alloy film. It is surmised that it is because the corrosion suppressing effect of Mg was not sufficient and the corrosion due to chlorine (Cl) occurred.

In a multilayer film of Comparative Example 104 including an Ag alloy film formed by using the Ag alloy sputtering target of Comparative Example 4 having a Mg content of 7.0 atom%, the sheet resistance was high.

In Comparative Example 5 in which the Ca content was set to 0.21 atom%, cracks occurred during rolling, and the sputtering target could not be manufactured. Accordingly, the subsequent evaluation was stopped.

In contrast, in a multilayer film Examples 101 to 109 of the present invention including Ag alloy films formed by using Ag alloy sputtering targets of Examples 1 to 9 containing Mg in a range of 1.0 atom% or more and 5.0 atom% or less and Au in a range of 0.10 atom% or more and 5.00 atom% or less, for example, as shown in Figs. 2A and 2B, after the constant temperature and humidity test, a discolored part was observed on the Ag alloy film. It was confirmed that the corrosion due to chlorine (CI) was suppressed by the corrosion suppressing effect of Mg and Au.

In addition, it was confirmed that the sheet resistance is sufficiently low, the average transmittance is sufficiently high, and the electrical characteristics and the optical characteristics are excellent, and the Ag alloy film is suitable as a transparent conductive film.

In addition, in Examples 7 and 8 of the present invention, Ca was contained in amount of 0.01 atom% and 0.15 atom%, but in all of the above examples, no corrosion was observed after the constant temperature and humidity test and the electrical characteristics and optical characteristics were excellent.

In addition, in the Ag alloy sputtering target of Examples 1 to 8 of the present invention in which the oxygen content is set to 0.010 % by mass or less, the occurrence of abnormal discharge during the sputtering film formation was sufficiently suppressed, and it is possible to stably perform the sputtering film formation.

In the Ag alloy sputtering target of Example 9 of the present invention in which the oxygen content is set to 0.030 % by mass, the abnormal discharge occurred during sputtering film formation, but an Ag alloy film could be formed. Also, in the multilayer film of Example 109 of the present invention including an Ag alloy film formed by using the Ag alloy sputtering target of Example 9 of the present invention, the environmental resistance was sufficiently excellent, compared to the comparative examples.

From the above, according to the examples of the present invention, it was confirmed that it is possible to provide an Ag alloy sputtering target capable of suppressing corrosion due to chlorine (CI) and forming an Ag alloy film having excellent environmental resistance, and an Ag alloy film.

### [Industrial Applicability]

According to the present invention, it is possible to provide an Ag alloy sputtering target capable of suppressing corrosion due to chlorine (Cl) and forming an Ag alloy film having excellent environmental resistance, and an Ag alloy film.

## Claims

1. An Ag alloy sputtering target comprising:
Mg in a range of 1.0 atom% or more and 5.0 atom% or less;
Au in a range of 0.10 atom% or more and 5.00 atom% or less; and
a balance consisting of Ag and inevitable impurities.

2. The Ag alloy sputtering target according to Claim 1, further comprising:
Ca in a range of 0.01 atom% or more and 0.15 atom% or less.

3. The Ag alloy sputtering target according to Claim 1 or 2,
wherein an oxygen content is 0.010 % by mass or less.

4. An Ag alloy film comprising:
Mg in a range of 1.0 atom% or more and 5.0 atom% or less;
Au in a range of 0.10 atom% or more and 5.00 atom% or less; and
a balance consisting of Ag and inevitable impurities.

5. The Ag alloy film according to Claim 4, further comprising:
Ca in a range of 0.01 atom% or more and 0.15 atom% or less.

6. The Ag alloy film according to Claim 4 or 5,
wherein an oxygen content is 0.010 % by mass or less.
